# EUROPEAN PATENT APPLICATION

(11) **EP 2 434 297 A1**
(43) Date of publication of application: **28.03.2012**
(21) Application number: 09844914.3
(22) Date of filing: 21.05.2009
(51) Int. Cl.: G01P 15/08, G01P 15/12, G01P 15/18, H01L 29/84, H01L 21/60

(54) **STRUCTURE HAVING CHIP MOUNTED THEREON AND MODULE PROVIDED WITH THE STRUCTURE**

(71) Applicant: Panasonic Corporation, Osaka 571-8501 (JP)
(72) Inventor: HAYASHI, Shintarou, Kadoma-shi Osaka 571-8686 (JP); UEDA, Mitsuhiko, Kadoma-shi Osaka 571-8686 (JP); SANAGAWA, Yoshiharu, Kadoma-shi Osaka 571-8686 (JP); SAKAI, Takamasa, Kadoma-shi Osaka 571-8686 (JP)
(74) Representative: Strehl Schübel-Hopf & Partner
(86) International application number: PCT/JP2009/059347
(87) International publication number: WO 2010/134181

(57) **Abstract**

A mounting structure of chip comprises a substrate having a base, a chip on the upper surface of the base, and adhesive agents which bonds the base and the first chip. The adhesive agent is applied to the upper surface of the base. The chip has a rectangular shape to have a width and a length, and is bonded at its lower surface to the base. The adhesive agents comprises the first adhesive agent, the second adhesive agent, and the third adhesive agent which are disposed on the three spots of the upper surface of the base, respectively. The three spots on the base are located on vertexes of a triangle. The first chip is bonded to the base by only the first adhesive agent, the second adhesive agent, and the third adhesive agent.

## Description

### TECHNICAL FIELD

This invention relates to a mounting structure of the chip comprising a substrate, a chip which is realized by the semiconductor device and which is disposed on the upper surface of the substrate, and the adhesive agent for bonding the substrate and the chip. In addition, this invention relates to a module comprising the mounting structure of chip.

### BACKGROUND ART

Japanese patent application publication No. 2006-133123A discloses a prior module. The prior module comprises a substrate, an acceleration sensor, and an adhesive agent. The substrate has a rectangular shape. The substrate is provided at its upper surface with four arrangement portions. The adhesive agents are disposed on the four arrangement portions. The acceleration sensor is, so called, the chip. The acceleration sensor has a size which is smaller than a size of the substrate. The acceleration sensor is, so called, the semiconductor device. The acceleration sensor is shaped to have a rectangular shape. The acceleration sensor has a rectangular shape. The acceleration sensor is provided at its four corners of the lower surface with adhesive portions. The acceleration sensor is attached to the upper surface of the substrate such that each the arrangement spot and each the adhesive portion is bonded by the adhesive agent. That is, the acceleration sensor has a mounting structure that the four corners of the acceleration sensor and the substrate are bonded by the adhesive agent.

The acceleration sensor is assembled as follows. Firstly, the adhesive agent is applied to the four arrangement spots of the substrate. Subsequently, the acceleration sensor is disposed on the upper surface of the substrate through each the adhesive agent such that each the arrangement spot is faced to the adhesive portion. The substrate, the adhesive agents, and the acceleration sensor are heated at, for example, 150 degree C. When the adhesive agents are heated, the acceleration sensor and the substrate are bonded by the adhesive agent. Then, the substrate, the adhesive agent, and the acceleration sensor are cooled to room temperature. In this manner, the acceleration sensor is assembled.

However, when the substrate, the adhesive agent, and the acceleration sensor are heated to 150 degree C, the substrate is changed into a warpage condition from a normal condition. Then, the acceleration sensor and the substrate which has the warpage are bonded by the adhesive agent. Subsequently, when the substrate having the warpage, the adhesive agent, and the acceleration sensor are cooled to the room temperature, the substrate is changed into the normal condition from the warpage condition. However, the acceleration sensor and the warped substrate are bonded by the adhesive agent. Therefore, when the substrate is changed into the normal condition from the warpage condition, the acceleration sensor receives the stress.

### DISCLOSURE OF THE INVENTION

### PROBLEM TO BE SOLVED BY THE INVENTION

This invention is produced to solve the above problem. A first objective of this invention is to produce a mounting structure of chip which is configured to reduce the stress applied to the chip. In addition, a second objective of this invention is to produce the module having the mounting structure of chip of the above.

In order to solve the above problem, this invention discloses a mounting structure of chip which comprises a substrate having a base, a first chip disposed on an upper surface of the base, and adhesive agents which is configured to bond the first chip to the base. The adhesive agents are disposed on the upper surface of the base. The first chip is shaped to have a rectangular shape, whereby the first chip has a width and a length. The first chip is bonded at its lower surface to the base by the adhesive agents. The adhesive agents comprise only the first adhesive agent, the second adhesive agent, and the third adhesive agents. The first adhesive agent, the second adhesive agent, and the third adhesive agents are disposed on the three spots of the upper surface of the base, respectively. The three spots of the upper surface of the base are not arranged in a row. Therefore, when the three spots of the upper surface of the base are connected by the connecting lines, the connecting lines form the triangle. Therefore, the three spots of the upper surface of the base have arrangement such that the three spots are located in the vertexes of the triangle which is formed by the connecting lines which connects the three spots with each other. The first chip is bonded to the base by only the first adhesive agent, the second adhesive agent, and the third adhesive agent.

When the first chip is mounted on the substrate, the substrate is deformed according to the increase of the temperature. Then, the substrate is changed into normal condition when the substrate is cooled to the room temperature. However, the above configuration makes it possible to prevent the first chip from receiving the stress due to the deformation caused by the temperature variation of the substrate.

The first chip further comprises a plurality of the first pad electrodes. The first pad electrodes are disposed on the upper surface of the first chip. "The first adhesive agent and the second adhesive agent" are located in one lengthwise end of the first chip, and "the third adhesive agent" is located in a remaining lengthwise end of the first chip, the remaining lengthwise end of the first chip is opposite of the one lengthwise end of the first chip. The first adhesive agent is located in one width end of the first chip and the second adhesive agent is located in a remaining width end of the first chip, the remaining width end of the first chip is opposite to the one width end of the first chip. All the first pad electrodes are arranged in the width direction on the upper surface of the first chip such that all said first pad electrode is located between the first adhesive agent and the second adhesive agent. In addition, all the first pad electrodes are located in the one lengthwise end of the first chip, the one lengthwise end of the first chip is located away from the third adhesive agent.

In this case, it is possible to make a bonding of the bonding wires to the first pad electrodes, respectively.

In addition, the first chip further comprises a plurality of the first pad electrodes. A plurality of the first pad electrodes are disposed on the upper surface of the first chip. "The first adhesive agent and the second adhesive agent" are located in one lengthwise end of the first chip, and the third adhesive agent is located in a remaining lengthwise end of the first chip. The remaining lengthwise end of the first chip is opposite of the one lengthwise end of the first chip. The first adhesive agent is located in one width end of the lower surface of the first chip and the second adhesive agent is located in a remaining width end of the lower surface of the first chip. The remaining width end of the lower surface of the first chip is opposite of the one width end of the lower surface of the first chip. A plurality of the first pad electrodes comprises a first electrode row and a second electrode row. The first electrode row, the first adhesive agent, and the second adhesive agent are arranged in the width direction of the first chip. The second electrode row, the first adhesive agent, and the third adhesive agent are arranged in the length direction of the first chip.

In this case, it is possible to make a stable bonding of each the bonding wire with respect to each the first pad electrode.

It is preferred that the module has above mentioned mounting structure of chip. The module comprises a second chip, a fourth adhesive agent, a fifth adhesive agent, and a sixth adhesive agent in addition to the substrate, the first chip, the first adhesive agent, the second adhesive agent, and the third adhesive agent. The fourth adhesive agent, the fifth adhesive agent, and the sixth adhesive agent are disposed on only the three spots of the upper surface of the first chip, respectively. The three spots of the upper surface of the first chip are not arranged in a straight line. Therefore, the connecting lines which connect the three spots of the upper surface of the first chip with each other forms a triangle. Therefore, the three spots of the upper surface of the first chip have an arrangement such that the three spots are located in the vertexes of the triangle which is formed by the connecting line which connects the three points with each other. The first chip has a plurality of the first pad electrodes. The pad electrodes are disposed on the upper surface of the first chip. The second chip is bonded to the first chip by the fourth adhesive agent, the fifth adhesive agent, and the sixth adhesive agent such that all the first pad electrode are exposed to the upper direction.

The second chip has a linear coefficient of expansion which is different from a linear coefficient of expansion of the first chip. Therefore, the second chip is greatly deformed according to the temperature increase of the second chip when the second chip is mounted on the first chip. In addition, when the second chip is cooled to the room temperature, the second chip is changed into the flat condition. However, this configuration makes it possible to bond the second chip to the first chip under a condition where the second chip has an inclination with respect to the first chip. The inclination releases the stress due to the deformation caused by the temperature variation of the second chip.

The first adhesive agent is preferably aligned with the fourth adhesive agent in the thickness direction of the first chip. Similarly, it is preferred that the second adhesive agent is aligned with the fifth adhesive agent. Similarly, the sixth adhesive agent is preferably aligned with the sixth adhesive agent.

In this case, it is possible to stably adhere the second chip to the upper surface of the first chip.

The substrate preferably comprises a step and a peripheral wall. The step extends in the upper direction from the outer end of the base. The step has "a step upper surface". The step upper surface has a first height from the upper surface of the base. The peripheral wall extends to the upper direction from an entire circumference of the base and the step such that the peripheral wall surrounds the base and the step. The second chip has a rectangular shape, whereby the second chip has a width and a length. The second chip has one lengthwise end and a remaining lengthwise end opposite of the one lengthwise end. The one lengthwise end of the lengthwise end of the second chip is defined as the overlapping portion. The remaining lengthwise end of the second chip is bonded to the first chip by the fourth adhesive agent and the fifth adhesive agent. The overlapping portion has a lower surface having a second height from the upper surface of the base. The second height is greater than the first height. The second chip is disposed on the upper surface of the first chip such that the overlapping portion is overlapped with the step upper surface. The module further comprises the seventh adhesive agent. The seventh adhesive agent is disposed between "the lower surface of the overlapping portion" and the step upper surface. The seventh adhesive agent is configured to bond the lower surface of the overlapping portion to the step upper surface.

In this case, it is possible to make a stable wire bonding with respect to the upper surface of the second chip.

It is preferred that the four adhesive agent is located in one width end of the second chip, and the fifth adhesive agent is located in a remaining width end of the second chip. The remaining width end of the second is opposite of the one width end of the second chip.

In this case, it is possible to make a stable wire bonding with respect to the upper surface of the second chip.

The seventh adhesive agent is preferably located in the one width end of the second chip and the remaining width end of the second chip such that the seventh adhesive agent is located in two corners of the second chip.

In this case, it is possible to make a stable wire bonding with respect to the upper surface of the second chip.

The substrate preferably comprises the connecting electrodes. The connecting electrodes are disposed on the three spots of the substrate. The first chip has a plurality of the terminal electrodes. The terminal electrodes are located in the lower surface of the first chip such that the terminal electrodes are located in positions corresponding to the connecting electrodes. The first adhesive agent, the second adhesive agent, and the third adhesive agent are defined by the bumps. Each the terminal electrode is coupled to each the connecting electrode through the bump.

When the first chip is mounted on the substrate, the temperature of the substrate is varied. However, the above configuration makes it possible to prevent the deformation of the first chip due to the stress.

It is preferred that the first chip is a MEMS device. The MEMS device comprises a movable portion. The MEMS device has a plurality of the first pad electrodes. Each the first pad electrode is spaced from the movable portion.

In addition, it is preferred that the first chip is an acceleration sensor. The acceleration sensor has a frame, a weight, a diaphragm, a piezoresistance, and a plurality of the first pad electrodes. The weight is disposed in an inside of the frame. The diaphragm is configured to couple the upper end of the weight with an upper end of the frame such that the weight is spaced from the frame by a predetermined gap. The diaphragm has flexibility. The piezoresistance is provided to the diaphragm. The piezoresistance is varied its resistance value according to a flexure due to the swinging of the weight. The piezoresistance is electrically connected to a plurality of the first pad electrodes.

According to the above features, it is possible to prevent the deformation of the movable portion of MEMS device and the acceleration sensor.

It is preferred that the first adhesive agent, the second adhesive agent, and the third adhesive agent further comprise encapsulation resins, respectively. The encapsulation resin is configured to encapsulate the bump.

According to this configuration, it is possible to ensure the connection of the first chip with respect to the substrate.

It is preferred that the substrate is provided with projections. The projection is formed to be projected toward an upper direction from the upper surface of the base. The projections are located in three spots of the upper surface of the base, respectively. The projections are covered by the adhesive agent.

In this case, it is possible to leave a space having a predetermined distance between an entire of the lower surface of the first chip and the entire of the upper surface of the base.

It is preferred that the first adhesive agent, the second adhesive agent, and the third adhesive agent comprise the silicone series resins, respectively.

In this case, it is possible to prevent the stress caused in the substrate from being transferred to the first chip.

Further, it is preferred that the first adhesive agent, the second adhesive agent, and the third adhesive agent are made of resin with spacer having spherical shapes.

In this case, it is possible to leave the space having a predetermined distance between an entire of the lower surface of the first chip from an entire of the upper surface of the base.

The spacer is preferably made of glass or plastic.

This configuration makes it possible to stably leave the space having a predetermined distance from the substrate to the first chip.

The first adhesive agent, the second adhesive agent, and the third adhesive agent are preferably disposed in outer circumference of the first chip.

In this case, it is possible to bond the first chip to the substrate, stably.

It is preferred that the seventh adhesive agent is made of silicone series resin.

With this configuration, it is possible to prevent the stress caused in the substrate from being applied to the first chip.

It is preferred that at least one of the first adhesive agent, the second adhesive agent, and the third adhesive agent is a plurality of bumps.

It is preferred that the bump is located in the outer circumference of the first chip. In this case, it is possible to stably adhere the first chip to the substrate.

It is preferred that the bump is made of a solder.

The bump made of the solder is soft, compared with the bump made of Au. Therefore, the bump made of the solder has a high absorbing effect of the stress. Therefore, it is possible to prevent the stress caused in the substrate from being applied to the first chip.

It is preferred that the bump is made of an electrical conductive paste of silicone series.

The bump made of the electrical conductive paste of silicone series is soft, compared with the bump made of metal. Therefore, the bump made of the electrical conductive paste has a high stress absorbing effect. That is, this configuration makes it possible to prevent the stress caused by the deformation due to the temperature variation of the substrate from being applied to the first chip.

It is preferred that each one of the first adhesive agent, the second adhesive agent, and the third adhesive agent covers the lower side of the side surface of the first chip.

In addition, the first chip is preferably realized by the acceleration sensor. According to aforementioned feature, the second chip is preferably realized by the IC chip. The acceleration sensor has a frame, the weight, the diaphragm, the piezoresistance, the input terminal, and a plurality of the output terminals. The weight is disposed in an inside of the frame. The diaphragm is shaped to connect "an upper end of the weight" with "an upper end of the frame". The diaphragm has flexibility. The piezoresistance is disposed on the diaphragm. The piezoresistance is configured to vary its resistance value according to the flexure caused by the swinging of the weight. The piezoresistance receives the voltage from the voltage source in the outside through the input terminal. The piezoresistnace is configured to output the voltage signal which indicates the variation of the resistance value of the piezoresistance. The IC chip has an input terminal. The IC chip is configured to make an arithmetic processing of processing the voltage signal received in the input terminal, and calculate the acceleration. The IC chip is configured to output the acceleration through the third pad electrodes.

### BRIEF EXPLANATION OF THE DRAWINGS

Fig. 1A shows a top view of the module with the mounting structure of the chip in the first embodiment.
Fig. 1B shows a side cross sectional view of the module with the mounting structure of the chip in the first embodiment.
Fig. 2 shows a circuit diagram of the resistance Rx1 to Rz4.
Fig. 3A shows a schematic side view and a schematic perspective view of the module in the first embodiment.
Fig. 3B shows a schematic side view and a schematic perspective view of the module in the first embodiment.
Fig. 3C shows a schematic side view and a schematic perspective view of the module in the first embodiment.
Fig. 4A shows a top view of the module of a first modification of the first embodiment.
Fig. 4B shows a side cross sectional view of the module in the first modification of the first embodiment.
Fig. 5 shows an arrangement of the first adhesive agent, the second adhesive agent, and the third adhesive agent of the module in the first embodiment.
Fig. 6A shows a top view of the module with the mounting structure of the chip in the second embodiment.
Fig. 6B shows a side cross sectional view of the module with the mounting structure of the second embodiment.
Fig. 7A shows a top view indicating the manufacturing process of the module in the second embodiment.
Fig. 7B shows a top view indicating the manufacturing process of the module in the second embodiment.
Fig. 7C shows a top view indicating the manufacturing process of the module in the second embodiment.
Fig. 8A shows a top view of the module of the first modification of the second embodiment.
Fig. 8B shows a side cross sectional view of the module of the first modification of the second embodiment.
Fig. 9A shows a top view indicating a manufacturing process of the module of the first modification of the second embodiment.
Fig. 9B shows a top view indicating a manufacturing process of the module of the first modification of the second embodiment.
Fig. 9C shows a top view indicating a manufacturing process of the module of the first modification of the second embodiment.
Fig. 9D shows a top view indicating a manufacturing process of the module of the first modification of the second embodiment.
Fig. 9E shows a top view indicating a manufacturing process of the module of the first modification of the second embodiment.
Fig. 9F shows a top view indicating a manufacturing process of the module of the first modification of the second embodiment.
Fig. 10A shows a top view of the module of the second modification of the second embodiment.
Fig. 10B shows a side cross sectional view of the second modification of the second embodiment.

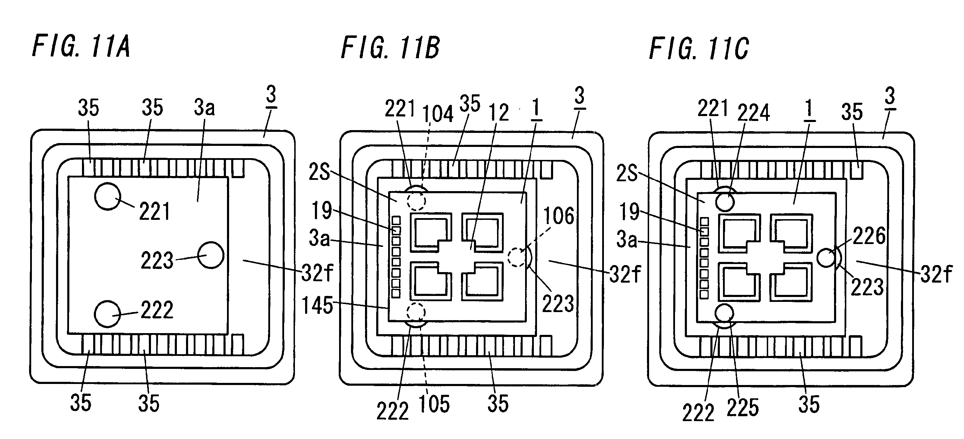

Fig. 11A shows a top view indicating the manufacturing process of the module of the second modification of the second embodiment
Fig. 11B shows a top view indicating the manufacturing process of the module of the second modification of the second embodiment
Fig. 11C shows a top view indicating the manufacturing process of the module of the second modification of the second embodiment

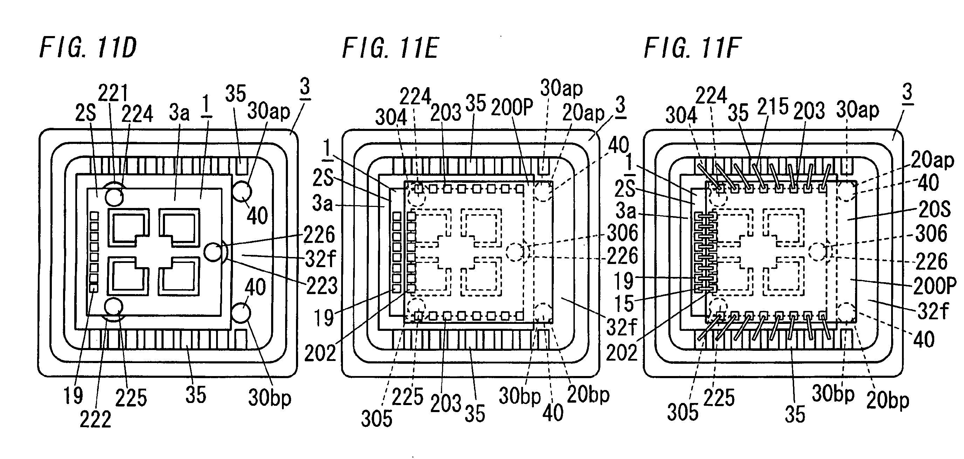

Fig. 11D shows a top view indicating the manufacturing process of the module of the second modification of the second embodiment
Fig. 11E shows a top view indicating the manufacturing process of the module of the second modification of the second embodiment
Fig. 11F shows a top view indicating the manufacturing process of the module of the second modification of the second embodiment
Fig. 12A shows a schematic top view of the module with the mounting structure of the chip of the third embodiment.
Fig. 12B shows a schematic side view of the module with the mounting structure of the chip of the third embodiment.
Fig. 13A shows a top view of the module of the third embodiment.
Fig. 13B shows a side view of the module of the third embodiment.
Fig. 14A shows a schematic perspective view indicating the substrate and the chip which are bonded by the bump.
Fig. 14B shows a schematic perspective view indicating the substrate and the chip which are bonded by the bump.
Fig. 14C shows a schematic perspective view indicating the substrate and the chip which are bonded by the bump.
Fig. 15A shows a top view of the module in the first modification of the third embodiment.
Fig. 15B shows a side view of the module in the first modification of the third embodiment.
Fig. 16A shows a top view of the module of the modification of the first embodiment.
Fig. 16B shows a side cross sectional view of the module of the first embodiment.

### BEST MODE FOR CARRYING OUT THE INVENTION

### (FIRST EMBODIMENT)

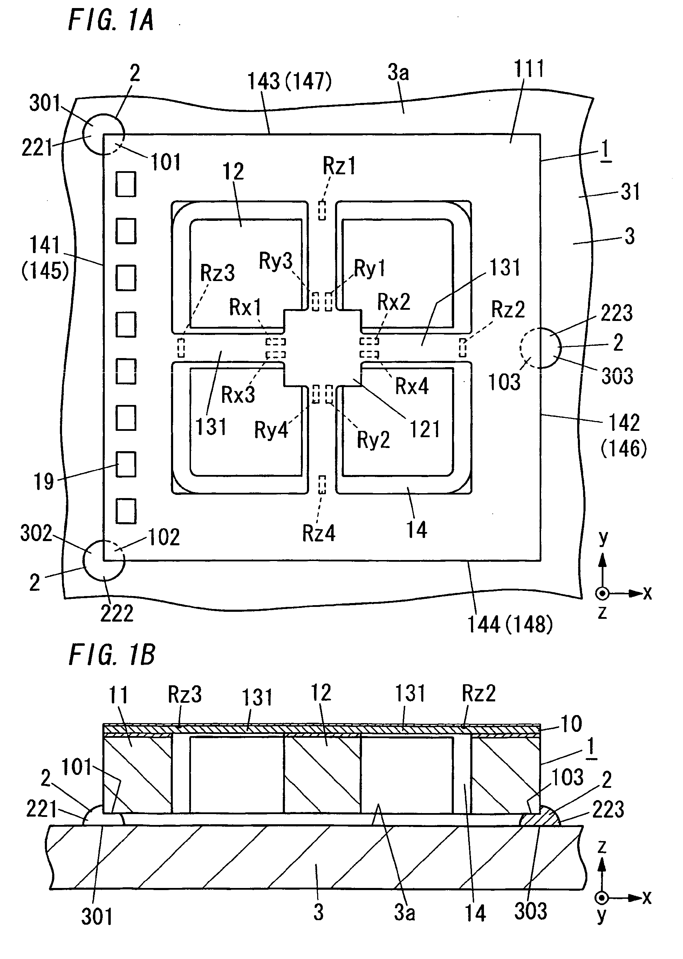

Hereinafter, an explanation of the module having the mounting structure of the chip in the first embodiment is made with attached drawings. Fig. 1A shows a top view of the module having the mounting structure of the chip in this embodiment. In Fig. 1, the arrowed line X indicates the right direction of the module. The arrowed line Y indicates the front direction of the module. The arrowed line Z is set perpendicular to both the arrowed line X and the arrowed line Y. That is, the arrowed line Z indicates the upper-lower direction of the module. Fig. 1B shows a side cross sectional view of the module having the mounting structure of the chip in this embodiment. The module in this embodiment comprises the substrate **3,** the acceleration sensor **1,** and the adhesive agents **2.**

The substrate **3** is made of material such as a ceramic and a glass epoxy resin. The substrate **3** is provided at its surface with a wiring which is omitted in the illustration. In this embodiment, the substrate **3** comprises a base **31.** The base **31** has "a base upper surface **3a".** The base upper surface **3a** is provided with a first arrangement spot **301,** a second arrangement spot **302,** and a third arrangement spot **303.** As will be understood from Fig. 1A, the first arrangement sport **301,** the second arrangement spot **302,** and the third arrangement sport **303** are not arranged in a row. Therefore, the connecting lines of the first arrangement spot **301,** the second arrangement spot **302,** and the third arrangement spot **303** forms a triangle. That is, the first arrangement spot **301,** the second arrangement spot **302,** and the third arrangement spot **303** are positioned in vertexes of the triangle. Each one of the first arrangement spot **301,** the second arrangement spot **302,** and the third arrangement spot **303** is provided at its upper surface with the adhesive agent **2.**

The adhesive agent **2** is made of silicone series resin. The adhesive agents **2** comprises only the first adhesive agent **221,** the second adhesive agent **222,** and the third adhesive agent **223.** In addition, it is preferred that the adhesive agent **2** further comprises a spherical-shaped spacer. In this case, the base **31** and the acceleration sensor **1** are arranged to leave the distance which is determined by the diameter of the spherical shaped spacer. Consequently, the acceleration sensor **1** is spaced from a base **31** to leave a predetermined distance. In addition, it is possible to effectively prevent the stress caused to the base from being applied to the acceleration sensor **1.** In addition, the spacer is preferably made of glass or plastic. In this case, it is possible to improve the accuracy of dimension of the spacer. Therefore, it is possible to uniform the distance between the acceleration sensor **1** and the base **31,** accurately. Furthermore, it is preferred that the adhesive agent **2** further comprise the spacer having a dimension of **3** micrometers to **30** micrometers. In addition, it is preferred that the adhesive agent **2** comprises the silicone resin which contains **1** percent to **20** percents of spacer.

The acceleration sensor defines the first chip. The acceleration sensor **1** has a rectangular shape. Therefore, the acceleration sensor **1** has an upper surface and a lower surface. The acceleration sensor **1** has a width and a length. The acceleration sensor **1** has a frame **11,** a diaphragm **10,** a weight **12,** resistors **Rx1, Rx2, Rx3, Rx4,** resistors **Ry1, Ry2, Ry3, Ry4,** resistors **Rz1, Rz2, Rz3, Rz4,** and the first pad electrode **19.**

As shown in Fig. 1B, the frame **11** has a rectangular shape. The frame **11** is formed at its center with an opening which penetrates in the thickness direction of the frame **11.** Therefore, the frame **11** has "an upper surface having a rectangular shape perpendicular to the thickness direction of the frame **11"** and "a lower surface having a rectangular shape perpendicular to the thickness direction of the frame **11".** In addition, as will be understood from Fig. 1A and Fig. 1B, the frame **11** is provided at outer periphery of the lower surface with a first side **141,** a second side **142,** a third side **143,** and a fourth side **144.** The first side **141** is opposite of the second side **142** in the lower surface of the frame **11.** The third side **143** and the fourth side **144** are located adjacent to the first side **141,** and also are located adjacent to the second side **142.** The third side **143** is opposite of the fourth side **144** in the lower surface of the frame **11.** The first end of the first side **141** is cooperative with the first end of the third side **143** to define the first adhesion spot **101.** The second end of the first side **141** which is opposite of the first end of the first side **141** defines the second adhesion spot **102.** One spot on the second side **142** defines the third adhesion spot **103.** That is, the first adhesion spot **101,** the second adhesion spot **102,** and the third adhesion spot **103** are located in the periphery of the lower surface of the frame **11.** The frame **11** has the upper surface. The diaphragm **10** is disposed on the upper surface of the frame **11.**

The diaphragm **10** is made of silicon. As will be understood from Fig. 1B, the diaphragm **10** is thinned. Therefore, the diaphragm **10** has flexibility. The diaphragm **10** has a dimension which is equal to the dimension of the frame **11.** The diaphragm **10** comprises the frame portion **111,** the beam **131,** and the holding portion **121.** The frame portion **111** has a thickness which is equal to the thicknesses of the four beams **131,** and also equal to the thickness of the holding portion. The holding portion **121** is located in a center of the frame portion **111.** Each one of the beams **131** has a first end which is coupled to the holding portion and a second end which is coupled to the inside circumferential surface of the frame portion **111.** Each one of the beams **131** is spaced from the other of the beams **131.** Consequently, the opening which is located in an inside of the frame portion **111** is divided by the beams **131** and the holding portion **121,** whereby the opening is divided into four sub-openings. The holding portion **121** is provided at its lower surface with a weight **12.**

As will be understood from Fig. 1B, the holding portion **121** has a certain portion which is overlapped with respect to the holding portion **121** in the thickness direction. The weight **12** is held by the certain portion of the holding portion **121.** In addition, the dimension of the plane which is perpendicular to the thickness direction of the weight **12** is set to be smaller than the dimension of the plane perpendicular to the thickness direction of the aperture of the frame **11.** Consequently, the weight **12** is disposed within the frame **11** such that the weight **12** is spaced from the frame **11** by a gap **14.** The gap **14** allows the weight to swing in the front-back direction and left-right direction according to the flexure of the beam **131.** In addition, the flexure of the beam **131** allows the weight to swing in the upper-lower direction.

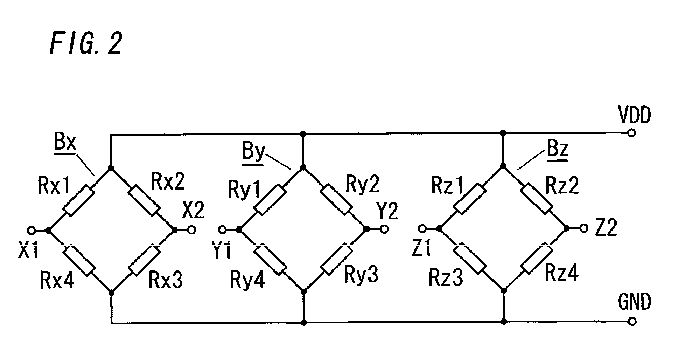

As shown in Fig. 1A, in the diaphragm **10,** the beam **131** which extends in the lateral direction has a connection portion which is connected to the holding portion **121.** The connection portion is provided with the resistors **Rx1, Rx2, Rx3,** and **Rx4.** The resistors **Rx1, Rx2, Rx3,** and **Rx4** are provided for detecting the acceleration in the X-axis direction. In addition, in the diaphragm **10,** the beam **131** which extends in the front-back direction has a connection portion which is connected to the holding portion **121.** The connection portion is provided with the resistors **Ry1, Ry2, Ry3,** and **Ry4.** The resistors **Ry1, Ry2, Ry3,** and **Ry4** are provided for detecting the acceleration in the Y-axis direction. In addition, in the diaphragm **10,** the frame portion **111** has a connection portion which is connected to the holding portion **121.** The connection portion is provided with the resistors **Rz1, Rz2, Rz3,** and **Rz4.** The resistors **Rz1, Rz2, Rz3,** and **Rz4** are provided for detecting the acceleration in the Z-axis direction. Each one of the resistors **Rx1** to **Rz4** is made of p-type semiconductor which comprises the silicon with dopant. That is, each the resistors **Rx1** to **Rx4** is realized by the piezoresistance. The resistors **Rx1, Rx2, Rx3,** and **Rx4** are connected by the wiring which is not shown in the illustration such that the resistors **Rx1, Rx2, Rx3,** and **Rx4** form the bridge circuit **Bx** shown in Fig. 2. The resistors **Ry1, Ry2, Ry3,** and **Ry4** are connected by the wiring which is not shown in the illustration such that the resistors **Ry1, Ry2, Ry3,** and **Ry4** forms the bridge circuit **By** shown in Fig. 2. The resistor **Rz1, Rz2, Rz3,** and **Rz4** are connected by the wiring which is not shown in the illustration such that the resistors **Rz1, Rz2, Rz3,** and **Rz4** form the bridge circuit **Bz** shown in Fig. 2. In addition, the bridge circuits **Bx, By,** and **Bz** are arranged in parallel with each other. The voltage is applied to each the bridge circuit **Bx, By,** and **Bz** through the input terminal **VDD.** In contrast, each the bridge circuit **Bx, By,** and **Bz** has an output terminals **X1, X2, Y1, Y2, Z1,** and **Z2.** The input terminal **VDD** is connected to the output terminals **X1** to **Z2.** The ground (earth) **GND** is connected to the first pad electrode **19** through a wiring which is not shown in the illustration. The first pad electrode **19** is connected to the power source in the outside, the voltage detection circuit, and the ground electrode (earth electrode) through the wiring which is not shown in the illustration. The voltage is applied to the input terminal **VDD** from the power source in the outside. The ground (earth) **GND** is connected to the ground electrode (earth electrode) in the outside. The output terminals **Z1** to **Z2** are connected to the voltage detection circuit in the outside. The voltage detection circuit is configured to detect the acceleration in the X-direction, Y-direction, and Z-direction according to the variation of the voltage output from the bridge circuit **Bx, By,** and **Bz.**

In addition, the diaphragm **10** is provided at its periphery of the upper surface with a fifth side **145,** a sixth side **146,** a seventh side **147,** and a eighth side **148.** The fifth side **145** and the seventh side **147** extend in parallel with each other. The fifth side **145** is opposite of the first side **141** in the acceleration sensor. The fifth side **145** is aligned with the first side **141** in the thickness direction of the acceleration sensor **1.** The sixth side **146** is opposite of the second side **142** in the thickness direction of the acceleration sensor **1.** The sixth side **146** is aligned with the second side **142** in the thickness direction of the acceleration sensor **1.** The seventh side **147** is opposite of the third side **143** in the thickness direction of the acceleration sensor **1.** The seventh side **147** is aligned with the third side **143** in the thickness direction of the acceleration sensor **1.** The eighth side **148** is opposite of the fourth side **144** in the thickness direction of the acceleration sensor **1.** The eights side **148** is aligned with the fourth side **144** in the thickness direction of the acceleration sensor **1.**

The first pad electrodes **19** are arranged along the fifth side **145** on the upper surface of the diaphragm **10** such that the first pad electrodes **19** are located between the first arrangement spot **301** and the second arrangement spot **302.** That is, all the first pad electrodes **19,** the first arrangement spot **301,** and the second arrangement spot **302** are arranged in the Y-direction of the acceleration sensor **1.** The first pad electrode **19** comprises the input terminal **VDD,** the output terminals **X1** to **Z2,** and the ground **GND.**

As shown in Fig. 1B, the acceleration sensor **1** is attached to the base **31** through the adhesive agents on the first arrangement spot **301,** the second arrangement spot **302,** and the third arrangement spot **303.** Consequently, the first arrangement spot **301** is faced to the first adhesion spot **101.** The second arrangement spot **302** is faced to the second adhesion spot **102.** The third arrangement spot **303** is faced to the third adhesion spot **103.** Therefore, the first adhesive agent **221** is disposed on the first adhesion spot **301.** The second adhesive agent **222** is disposed on the second adhesion spot **302.** The third adhesive agent **223** is disposed on the third adhesion spot **303.**

When the acceleration sensor **1** is swung, the weight **12** is swung in the lateral direction defined by X-direction, the front-back direction defined by the Y-direction, and the upper-lower direction defined by the Z-direction. When the weight **12** is swung, each the beam **131** is flexed. When the beam **131** is flexed, the stretching stress and the compression stress are caused to the beam **131.** The stretching stress and the compression stress are applied to each the resistor **Rx1** to **Rz4.** Each the resistor **Rx1** to **Rz4** is realized by the piezoresistance. Therefore, the resistance values of the resistors **Rx1** to **Rz4** is increased when the resistors **Rx1** to **Rz4** receives the stretching stress. In contrast, the resistance value of the resistors **Rx1** to **Rz4** is decreased when the resistors **Rx1** to **Rz4** receive the compression stress. In this manner, the resistance value of the bridge circuit **Bx, By,** and **Bz** are varied. The bridge circuit **Bx, By,** and **Bz** receives the voltage through the input terminal **VDD.** Therefore, the output voltage of the bridge circuit **Bx, By,** and **Bz** is varied according to the resistance value of the bridge circuit **Bx, By,** and **Bz.** The variation of the output voltage is detected by the voltage detection circuit. Then, the module detects the acceleration on the basis of the detection result.

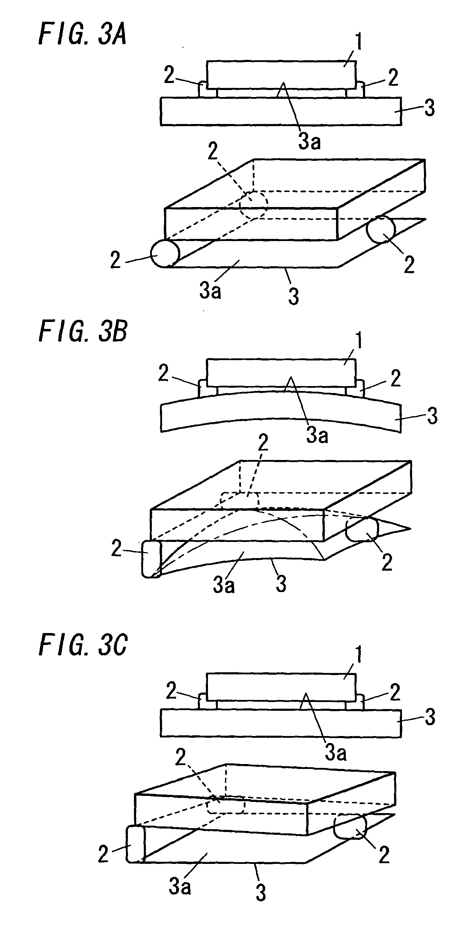

The acceleration sensor **1** is mounted on the base **31** as follows. At first, the adhesive agents **2** are applied to the first arrangement spot **301,** the second arrangement spot **302,** and the third arrangement spot **303** on the base upper surface **3a.** Then, the acceleration sensor **1** is disposed on the adhesive agents **2.** Consequently, the first arrangement spot **301** is faced to the first adhesion spot **101.** The second arrangement spot **302** is faced to the second adhesion spot **102.** The third arrangement spot **303** is faced to the third adhesion spot **103.** Consequently, the substrate **3,** the adhesive agent **2,** and the acceleration sensor **1** are arranged in the manner shown in Fig. 3A. The substrate **3,** the adhesive agent, and the acceleration sensor **1** are heated at 150 degrees. When the substrate **3,** the adhesive agent, and the acceleration sensor **1** are heated, the warpage of the substrate **1** is caused. Then, the substrate **3** is cooled to a room temperature. Consequently, the acceleration sensor **1** is adhered to the base **31** having warpage through the adhesive agents **2.** However, the acceleration sensor **1** is adhered to the substrate **3** through the three points of the first adhesive agent **221,** the second adhesive agent **222,** and the third adhesive agent **223.** Therefore, even if the stress is caused by changing from the warpage condition to the flat condition of the base **31,** the acceleration sensor **1** is fixed to the base **31** such that the acceleration sensor **1** is made inclination with respect to the base **31.** Consequently, the stress is released. However, the inclination is nanometer-level. Therefore, the inclination causes no effect with respect to the detection accuracy of the acceleration sensor **1.**

In this manner, the mounting structure of chip in this embodiment makes it possible to prevent the semiconductor device such as the acceleration sensor from being made deformation due to the warpage of the substrate. Therefore, it is possible to obtain the acceleration sensor which is free from the effect of the stress after the chip is mounted on the substrate.

In addition, all the first pad electrodes **19** are arranged along the fifth side **145** such that all the first pad electrodes **19** are located between the first adhesion spot **101** and the second adhesion spot **102.** That is, the first pad electrodes **19** are arranged along the fifth side **145** such that the first pad electrodes **19** are located between the first adhesive agent **221** and the second adhesive agent **222.** The first pad electrodes **19** are arranged along the fifth side **145** which is spaced away from the third adhesive agent **223.** Consequently, even if the stress is applied to the first pad electrodes **19** from the upside, the acceleration sensor **1** is stably supported by the substrate **3.** Therefore, it is possible to establish the bonding of the first pad electrodes by the bonding wire.

In addition, the adhesive agent **2** is made of silicone-series resin. The silicone-series resin has a low coefficient of elasticity. Therefore, the adhesive agent **2** made of the silicone series resin absorbs the stress applied to the acceleration sensor **1** from the substrate.

In addition, the adhesive agents **2** are disposed on the three spots of the substrate such that the adhesive agents **2** cover the lower side of the outer circumference of the acceleration sensor. Therefore, it is possible to prevent the acceleration sensor **1** from being come off when the acceleration sensor **1** receives the force in the front-back direction and the lateral direction.

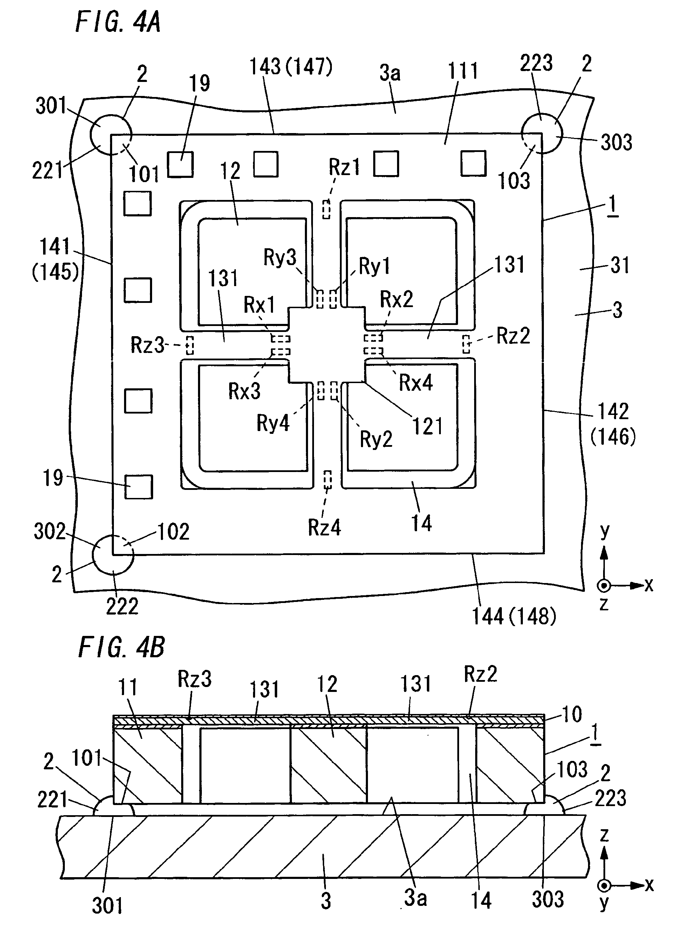

Fig. 4A show a top view of the module having the mounting structure of chip in the first modification of this embodiment. Fig. 4B shows a side cross sectional view of the module having the mounting structure of chip in the modification of this embodiment. In this modification, as shown in Fig. 4A and Fig. 4B, the first adhesion spot **101** is defined by the first end of the first side **141** and the first end of the third side **143.** The second adhesion spot **102** is defined by the second end, opposite of the first end, of the first side **141.** The third adhesion spot **103** is defined by the second end, opposite of the first end, of the third side **143.** Furthermore, as will be understood from Fig. 4A and Fig. 4B, all the first pad electrodes **19** comprises a first electrode row and a second electrode row. The first electrode row is arranged along the fifth side **145.** Therefore, the first electrode row is arranged in the Y-direction of the acceleration sensor **1** such that the first electrode row is located between the first adhesive agent **221** and the second adhesive agent **222.** The second electrode row is arranged along the seventh side **147.** Therefore, the second electrode row is arranged along the X-direction of the acceleration sensor **1** such that the second electrode row is located between the first adhesive agent **221** and the third adhesive agent **223.** The mounting structure of chip in this configuration also makes it possible to establish the stable bonding of the bonding wire with respect to each the first pad electrode **19.**

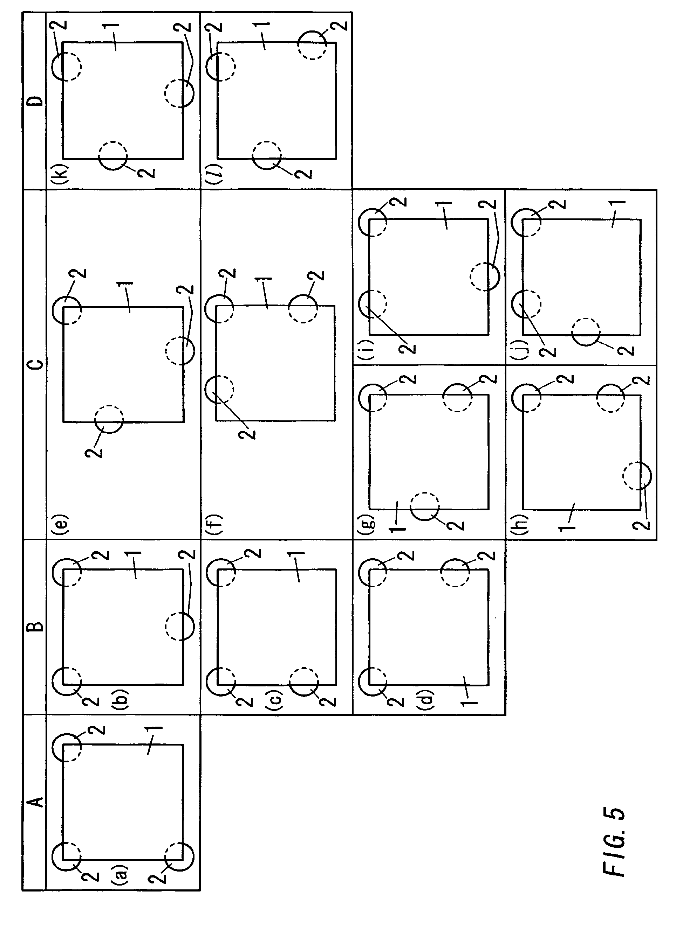

In addition, the arrangement of the adhesive agent **2** is not limited to the arrangement in the first embodiment and the modification of the first embodiment. The arrangement of the adhesive agent **2** of (a) to (I) shown in Fig. 5 also makes it possible to achieve the effect of the above. Specifically, the longitudinal row A of Fig. 5 shows all the adhesive agents **2** which are disposed in the three corners of the lower surface of the acceleration sensor **1.** The longitudinal row B of Fig. 5 shows two adhesive agents **2** which are disposed in two corners of the lower surface of the acceleration sensor **1.** The longitudinal row C of Fig. 5 shows one adhesive agent **2** which is disposed in one corner of the lower surface of the acceleration sensor. The longitudinal row D in Fig. 5 shows the adhesive agents **2** any one of which is disposed in corner of the acceleration sensor **1.** However, it is preferred that the adhesive agents **2** are disposed such that the triangle has a large dimension and the center of the triangle is located in a center of the semiconductor element.

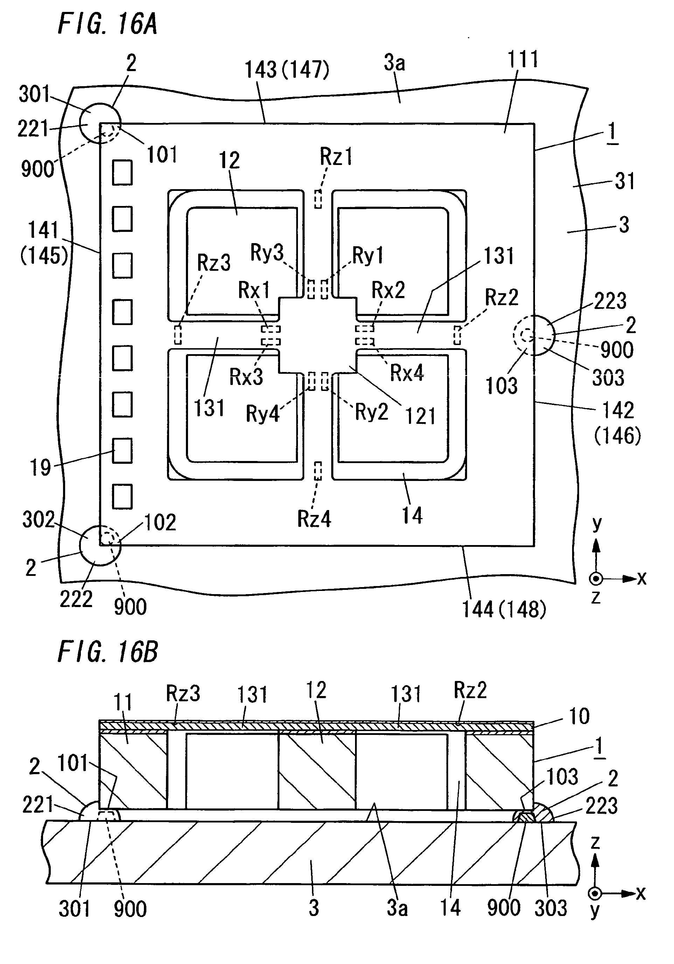

Fig. 16 shows the module of the mounting structure of chip in the second modification of this embodiment. In this modification, the base **31** is provided with the projections **900** which are located in the first arrangement spot **301,** the second arrangement spot **302,** and the third arrangement spot **303,** respectively. The projections **90** are located between "the arrangement spot **301** and the adhesion spot **101",** between " the arrangement spot **302** and the adhesion spot **102",** and between "the arrangement spot **303** and the adhesion spot **103",** respectively. The projections **900** are covered by the first adhesive agent **221,** the second adhesive agent **222,** and the third adhesive agent **223.** In addition, as will be understood from Fig. 16A, each one of the first adhesive agent **221,** the second adhesive agent **222,** and the third adhesive agent **223** are located between "the upper surfaces of the projections" and "the lower surface of the frame **11".** Consequently, even if the stress is caused when the base **31** is changed from the warpage condition into the flat condition, it is possible to release the stress. Furthermore, it is possible to leave a space between the base upper surface **3a** and the lower surface of the acceleration sensor by a uniform distance.

The explanation of the above embodiment is made with using the first chip which is defined by the acceleration sensor **1** of piezoresistance type. However, the first chip is not limited to the acceleration sensor of the piezoresistance type. That is, the mounting structure of chip of the above may be applied to "a MEMS device such as acceleration sensor of capacitance type, a gyro sensor, a pressure sensor, a micro-actuator, a micro-relay, a micro-valve, an infrared sensor", and "the module such as IC chip".

### (SECOND EMBODIMENT)

An explanation of the module with mounting structure of chip in the second embodiment of this invention is made with attached drawings. In addition, the components of this embodiment equivalent to the components of the first embodiments are symbolized by the same reference numerals of the first embodiment, whereby the explanations are omitted.

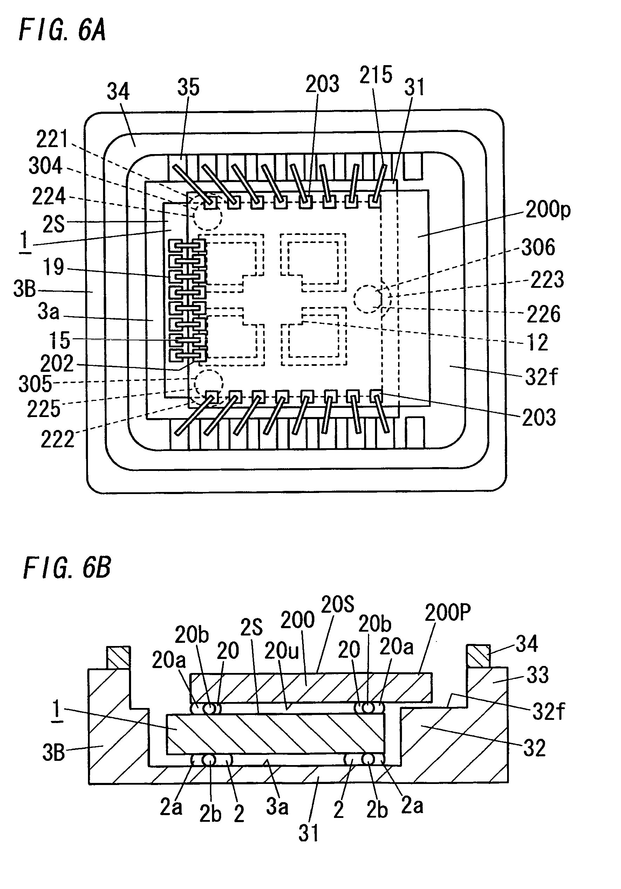

Fig. 6A shows a top view of the module in this embodiment. Fig. 6B shows a side cross sectional view of this embodiment. As will be understood from Fig. 6A and Fig. 6B, the module in this embodiment comprises the substrate **3B,** the adhesive agent **2,** the acceleration sensor **1,** the adhesive agent **20,** and the IC chip **200.**

The substrate **3B** is made of material such as a ceramic and a glass epoxy resin. The substrate **3** is formed to have the base **31,** the step **32,** and the peripheral wall **33.** The step **32** extends toward the upper direction from the periphery of the base **31.** The peripheral wall **33** extends toward the upper direction from the periphery of the base **31** and the step **32.** Consequently, the substrate **3B** has a box shape and is provided at its upper surface with an opening. The peripheral wall **33** is provided at its upper end with the adhesive agents **34.** The lid is attached to the peripheral wall **33** through the adhesive agent **34.** The step **32** has an upper surface which is defined as "a step upper surface **32f'.** "The step upper surface **32f'** has a first height from "the base upper surface **3a".** The step upper surface **32f** is provided with a plurality of the wirings **35.**

The adhesive agent **2** comprises the silicone series resin **2a** mixed with the spacers **2b** having the spherical shapes.

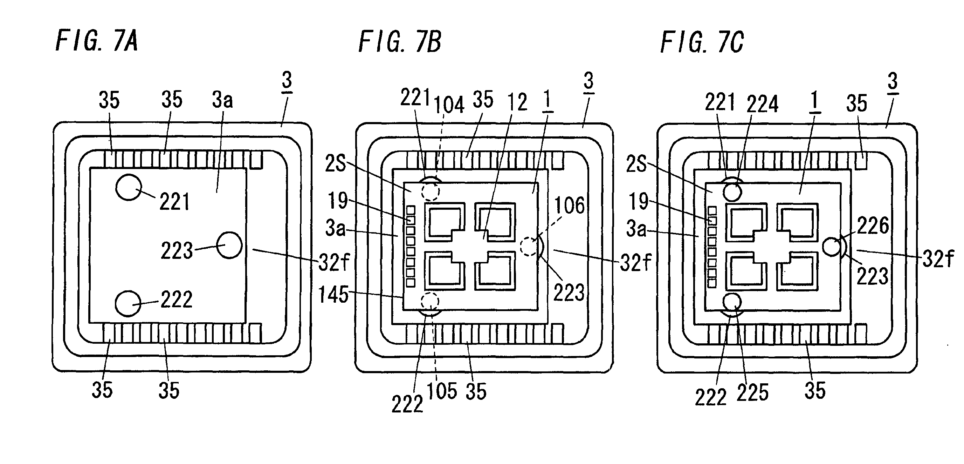

The acceleration sensor **1** is cooperative with the IC chip **200** to construct the semiconductor device. As will be understood from Fig. 7B, the acceleration sensor **1** has an upper surface which is defined as "a sensor upper surface **2S",** and is provide at its sensor upper surface **2S** with the fourth arrangement spot **104,** the fifth arrangement spot **105,** the sixth arrangement spot **106,** and a plurality of the first pad electrodes **19.** The fourth arrangement spot **104,** the fifth arrangement spot **105,** and the sixth arrangement spot **106** are not arranged in a row. Therefore, the connecting lines of the fourth arrangement spot **104,** the fifth arrangement spot **105,** and the sixth arrangement spot **106** forms a triangle. In addition, as shown in Fig. 7C, the fourth arrangement spot **104** is aligned with the first adhesion spot **301** in the thickness direction of the acceleration sensor **1.** Similarly, the fifth arrangement spot **105** is aligned in the second adhesion spot **302** in the thickness direction of the acceleration sensor **1.** Therefore, the fifth arrangement spot **105** and the sixth arrangement spot **106** are located in the first end in the longitudinal direction of the acceleration sensor **1.** The fifth arrangement spot **105** and the sixth arrangement spot **106** are located in one end in the width direction and the other end in the width direction of the acceleration sensor **1,** respectively. Similarly, the sixth arrangement spot **106** is aligned with the third adhesion spot **303** in the thickness direction of the acceleration sensor **1.** A plurality of the first pad electrodes **19** are arranged along the fifth side **145** such that a plurality of the first pad electrodes **19** are located between the fourth arrangement spot **104** and the fifth arrangement spot **105.**

The adhesive agent **20** is made of silicone series resin **20a** mixed with the spacers **20b** having spherical shapes. The adhesive agent **20** comprises the fourth adhesive agent **224,** the fifth adhesive agent **225,** and the sixth adhesive agent **226.** The adhesive agents **20** are only applied to the fourth spot **104,** the fifth spot **105,** and the sixth spot **106.**

The IC chip **200** is defined as the second chip. IC chip **200** has a rectangular shape. IC chip **200** has "an IC chip lower surface **20u** which is faced to the sensor upper surface **2S"** and "an IC chip upper surface **20S** which is opposite of the IC chip lower surface **20u".** The IC chip **200** is provided at its IC chip lower surface **20u** with the fourth adhesion spot **304,** the fifth adhesion spot **305,** and the sixth adhesion spot **306.** The IC chip **200** is disposed on the upper surface of the acceleration sensor **1** such that all the first pad electrodes **19** are exposed to the upper direction of the acceleration sensor **1.** In addition, the IC chip **200** is disposed on the upper side of the acceleration sensor **1.** Consequently, the fourth arrangement spot **104** is faced to the fourth adhesion spot **304.** The fifth arrangement spot **105** is faced to the fifth adhesion spot **305.** The sixth arrangement spot **106** is faced to the sixth adhesion spot **306.** Consequently, the lower surface of the IC chip **200** is located at a second height from the base upper surface **3a.** The second height is set to be greater than the first height.

The IC chip **200** has one longitudinal end defined as the first end and the other longitudinal end defined as the second end. The first end of the IC chip **200** is defined as an overlapping portion **200P.** The second end of the IC chip **200** has the fourth adhesion spot **304** and the fifth adhesion spot **305.** The fourth adhesion spot **304** is disposed in one width end of the lower surface of the IC chip **200** and the fifth adhesion spot **305** is disposed in the other width end of the lower surface of the IC chip **200.** Therefore, the overlapping portion **200P** has the lower surface which is located at a second height from the base upper surface **3a.** The IC chip **200** is disposed on the same side of the acceleration sensor **1** as the upper surface of upper surface of the acceleration sensor **1** such that the overlapping portion **200P** is overlapped with the step upper surface **32f.** The IC chip **200** has a length which is greater than a length of the acceleration sensor **1.**

The IC chip **200** is provided at its IC chip upper surface **20S** with "a plurality of the second pad electrodes **202"** and "a plurality of the third pad electrodes **203".** All the second pad electrodes **202** are disposed along one side of the IC chip upper surface **20S** such that all the second pad electrodes **202** are located between the fourth adhesion spot **304** and the fifth adhesion spot **305.** The second pad electrodes **202** are electrically connected to the first pad electrodes 19 through the bonding wires **15,** respectively. The second electrode pads **202** are connected to the third electrode pads **203,** respectively, through the wirings not shown in the illustration. The third pad electrodes **203** are arranged in a plurality of the sides of the IC chip upper surface **20S** such that the third pad electrodes **203** are arranged in parallel with a plurality of the wirings **35** of the substrate **3B.** The third pad electrodes **203** are electrically connected to the wirings **35,** respectively, through the bonding wires **215.** The wiring **35** is connected to the voltage source disposed in the outside. In this manner, the acceleration sensor **1** is connected to the power source provided in the outside. In addition, the IC chip is configured to calculate the acceleration on the basis of the voltage signal sent from the second pad electrodes **202.** The IC chip is configured to output a signal indicative of the acceleration to the through the third pad electrode.

The above acceleration sensor **1** and the IC chip **200** are mounted on the substrate **32** as follows. Firstly, as shown in Fig. 7A, the adhesive agents **2** are applied to the first arrangement spot **301,** the second arrangement spot **302,** and the third arrangement spot **303** of the base upper surface **3a.** Then, the acceleration sensor **1** is disposed on the upper surface of the adhesive agent **2.** Consequently, the first arrangement spot **301** is faced to the first adhesion spot **101.** The second arrangement spot **302** is faced to the second adhesion spot **102.** The third arrangement spot **303** is faced to the third adhesion spot **103.** Consequently, as shown in Fig. 7B, the substrate **3,** the adhesive agent **2,** and the acceleration sensor **1** are arranged. The substrate **3,** the adhesive agent **2,** and the acceleration sensor **1** are heated at 150 degrees C. When the substrate **3,** the adhesive agent **2,** and the acceleration sensor **1** are heated at 150 degrees C, the substrate heated at 150 degrees C is made warpage. Then, the substrate is cooled to the room temperature. Consequently, the acceleration sensor **1** is adhered to the substrate **3** having the warpage through the adhesive agent **2.** However, the acceleration sensor **1** is adhered to the substrate **3** through the three points of the first adhesive agent **221,** the second adhesive agent **22,** and the third adhesive agent **223.** Therefore, even if the stress is caused when the substrate **3** is changed from the warpage condition into the flat condition, the acceleration sensor **1** is fixed to the substrate such that the acceleration sensor is made inclination with respect to the substrate. Therefore, the inclination releases the stress. In addition, the inclination is nanometer level. Therefore, the inclination causes no effect of the detection accuracy of the acceleration sensor **1.** In addition, the acceleration sensor **1** is attached to the substrate **3** under a condition shown in Fig. 7B.

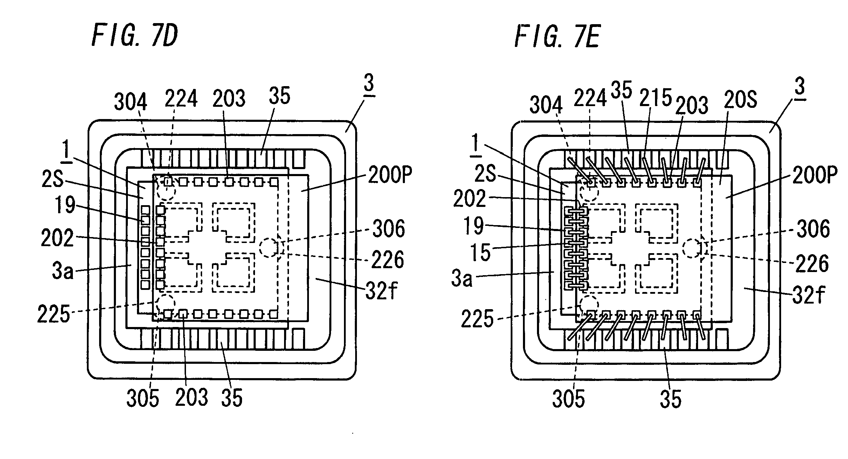

Subsequently, as shown in Fig. 7C, the adhesive agent **20** is applied to the fourth arrangement spot **104,** the fifth arrangement spot **105,** and the sixth arrangement spot **106** of the sensor upper surface **2S.** Then, the IC chip **200** is disposed on the same side of the acceleration sensor **1** as the upper surface of the acceleration sensor **1.** Consequently, the fourth arrangement spot **104** is faced to the fourth adhesion spot **304.** The fifth arrangement spot **105** is faced to the fifth adhesion spot **305.** The sixth arrangement spot **106** is faced to the sixth adhesion spot **306.** The first pad electrodes **19** are exposed to the upper side of the acceleration sensor **1.** The overlapping portion **200P** is overlapped with the step upper surface **32f.** Then, the substrate **3,** the adhesive agent **2,** the acceleration sensor **1,** the adhesive agent **20,** and the IC chip **200** are heated at 150 degrees C. It is noted that the acceleration sensor **1** has a linear coefficient of expansion which is different from a linear coefficient of expansion of the IC chip **200.** Therefore, the warpage of the acceleration sensor **1** is different from the warpage of the IC chip **200.** However, when the substrate **3,** the adhesive agent **2,** and the acceleration sensor **1** is cooled to the room temperature, the IC chip **200** is adhered to the acceleration sensor **200** under a condition where the IC chip **200** is inclined with respect to the acceleration sensor **1.** Therefore, the stress caused by the warpage of the IC chip **200** is released. Consequently, similar to the above, the acceleration sensor **1** is mounted on the substrate **3** without receiving the stress from the IC chip **200.** Consequently, the components have the arrangement shown in Fig. 7D. Then, as shown in Fig. 7E, the first pad electrodes **19** are electrically connected to the second pad electrodes **202** through the wires **15.** The third pad electrodes **203** are electrically connected to the wiring through the wire **215.**

The modules are operated as follows. The module receives the voltage from the voltage source in the outside of the module. When the voltage source applies the voltage, the voltage is applied to the input terminal **VDD** of the first pad electrodes **19** through the third pad electrodes. Consequently, each the piezoresistances **Rx1** to **Rz4** receives the voltage. Each the piezoresistances outputs the voltage signal from the output terminal **X1** to **Z2** of the first pad electrodes **19.** IC chip **200** receives the output signal through the wire **15** and the second pad electrode **202.** The IC chip **200** comprises the voltage detection circuit. The IC chip **200** calculates the acceleration on the basis of the output signal, and outputs the signal indicative of the acceleration through the third pad electrode **203,** the wire **215,** and the wiring **35.**

As explained above, the module with the mounting structure of chip of the above comprises the semiconductor device comprising the acceleration sensor **1** and the IC chip **200.** The semiconductor device is mounted on the base **31** through the first adhesive agent **221,** the second adhesive agent **222,** and the third adhesive agent **223** on the base upper surface **3a.** The IC chip **200** is mounted on the acceleration sensor **1** through the fourth adhesive agent **224,** the fifth adhesive agent **225,** and the sixth adhesive agent **226** on the upper surface of the acceleration sensor **1.** The first adhesive agent **221** is aligned with the fourth adhesive agent **224** in the thickness direction of the acceleration sensor **1.** The second adhesive agent **222** is aligned with the fifth adhesive agent **225** in the thickness direction of the acceleration sensor **1.** The third adhesive agent **223** is aligned with the sixth adhesive agent **226** in the thickness direction of the acceleration sensor **1.** Therefore, the adhesive agents **2** are aligned with the adhesive agents **20,** respectively, in the thickness direction of the acceleration sensor **1.** Therefore, it is possible to prevent the deformation of the acceleration sensor **1** due to the warpage caused in a situation where the acceleration sensor **1** is mounted on the substrate **1.** Therefore, the mounting structure of chip in this embodiment makes it possible to produce the semiconductor device which is free from the stress after mounting on the substgrate.

In addition, the adhesive agent **20** is made of silicone series resin. The silicone series resin has a low coefficient of elasticity. Therefore, the adhesive agent **20** made of silicone series resin makes it possible to prevent the transfer of the stress to the IC chip **200** through the acceleration sensor **1** from the substrate **3.**

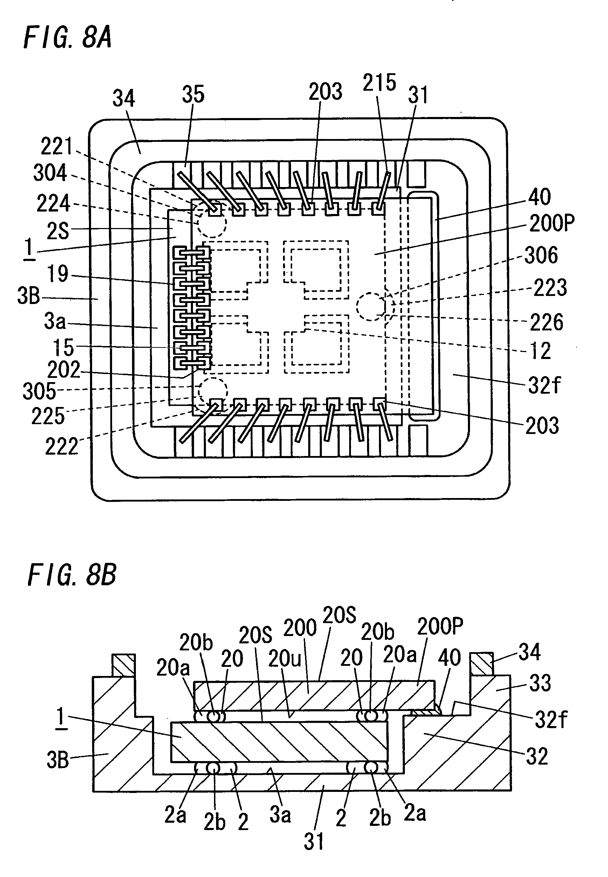

Fig. 8 shows the module in the first modification of this embodiment. As will be understood from Fig. 8, the module in this modification further comprises the seventh adhesive agent **40.** The seventh adhesive agent **40** is located between the step upper surface **32f** and the lower surface of the overlapping portion **200P.** Consequently, the seventh adhesive agent **40** bonds the step upper surface **32f** to the overlapping portion **200P.**

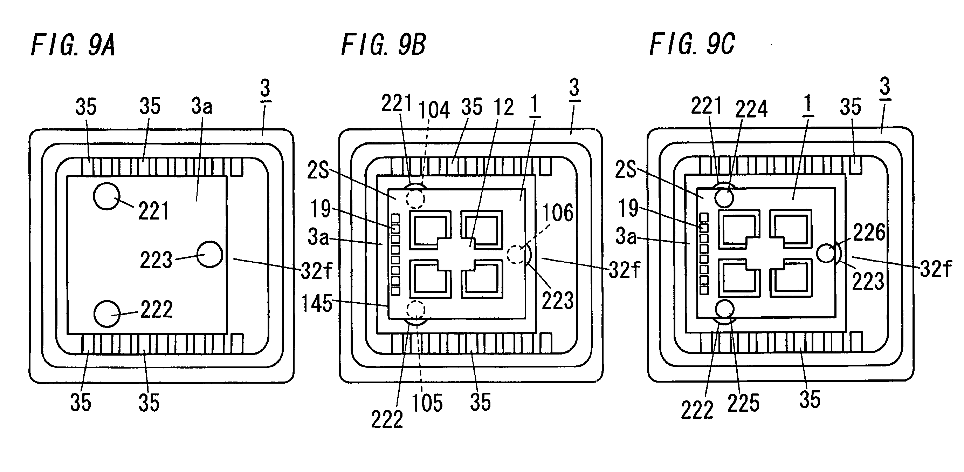

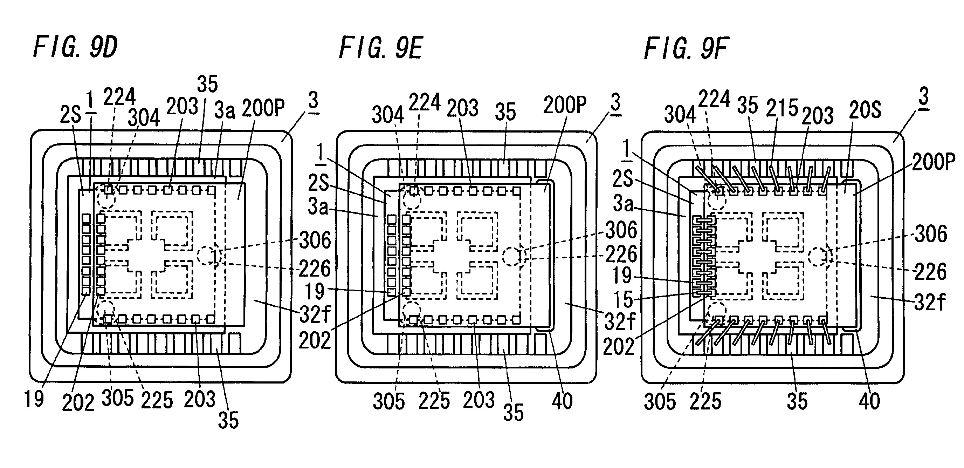

The acceleration sensor **1** and the IC chip **200** are mounted on the substrate **3** as follows. Firstly, as shown in Fig. 9A, the adhesive agents **2** are applied to the first arrangement spot **301,** the second arrangement spot **302,** and the third arrangement spot **303** on the base upper surface **3a.** Then, the acceleration sensor **1** is disposed on the upper surface of the adhesive agents **2.** Consequently, the first arrangement spot **301** is faced to the first adhesion spot **101.** The second arrangement spot **302** is faced to the second adhesion spot **102.** The third arrangement spot **303** is faced to the third adhesion spot **103.** Consequently, the substrate **3,** the adhesive agents **2,** and the acceleration sensor **1** have an arrangement shown in Fig. 9 **B.** The substrate **3,** the adhesive agent **2,** and the acceleration sensor **1** are heated at 150 degrees C. When the substrate **3,** the adhesive agent **2,** and the acceleration sensor **1** are heated at 150 degrees C, the substrate which is heated at 150 degrees C is warpaged. Then, the substrate **3,** the adhesive agents **2,** and the acceleration sensor **1** are cooled to the room temperature. Consequently, the acceleration sensor **1** is adhered to the substrate **3** having the warpage through the adhesive agent **2.** However, the acceleration sensor **1** is adhered to the substrate **3** through only the first adhesive agent **221,** the second adhesive agent **222,** and the third adhesive agent **223.** Therefore, even if the stress is caused when the substrate **3** is changed from the warpage condition into the flat condition, the acceleration sensor **1** is fixed to the substrate under a condition where the acceleration sensor **1** has an inclination with respect to the substrate. The inclination causes the release of the stress. In addition, the inclination is nanometer level. Therefore, the inclination causes no effect of the detection accuracy of the acceleration sensor **1.** Furthermore, the acceleration sensor is fixed to the substrate **3** to have a condition shown by Fig. 9B.

Subsequent to the above, as shown in Fig. 9C, the adhesive agents **20** are applied to the fourth spot **104,** the fifth spot **105,** and the sixth spot **106** on the sensor upper surface **2S.** Then, the IC chip **200** is mounted on the same side of the acceleration sensor **1** as the upper surface of the acceleration sensor **1.** Consequently, the fourth arrangement spot **104** is faced to the fourth adhesion spot **304.** The fifth arrangement spot **105** is faced to the fifth adhesion spot **305.** The sixth arrangement spot **106** is faced to the sixth adhesion spot **306.** The first pad electrodes **19** are exposed to the upper direction of the acceleration sensor **1.** The overlapping portion **200P** is located in a position such that the overlapping portion **200P** is spaced from the step upper surface **32f** to leave the gap **41.** Furthermore, the substrate **3,** the adhesive agent **2,** the acceleration sensor **1,** the adhesive agent **20,** and the IC chip **200** are heated at 150 degrees C. Consequently, similar to the above, the acceleration sensor **1** and the IC chip **200** are mounted on the substrate **3** without receiving the stress from the substrate **3.** Consequently, the components have an arrangement shown in Fig. 9D. Then, the gap **41** is filled with the seventh adhesive agent **40.** Then, the substrate **3,** the adhesive agent **2,** the acceleration sensor **1,** the adhesive agent **20,** the IC chip **200,** and the seventh adhesive agent **40** are heated at 150 degrees C. Consequently, the overlapping portion **200P** is adhered to the step upper surface **32f.** Then, as shown in Fig. 9F, the first pad electrodes **19** is electrically connected to the second pad electrodes **202** through the wires **15.** The third pad electrodes **203** are electrically connected to the wiring through the wire **215.**

As explained above, the module with mounting structure of chip comprises the IC chip **200** which has an overlapping portion **200P.** The IC chip **200** is disposed on the upper side of the substrate **3B** and on the upper side of the acceleration sensor **1** such that the gap **41** is left between the overlapping portion **200P** and the step upper surface **32f.** In addition, the gap **41** is filled with the seventh adhesive agent **40.** Therefore, it is possible to stably establish the wire bonding with respect to the second pad electrodes **202.**

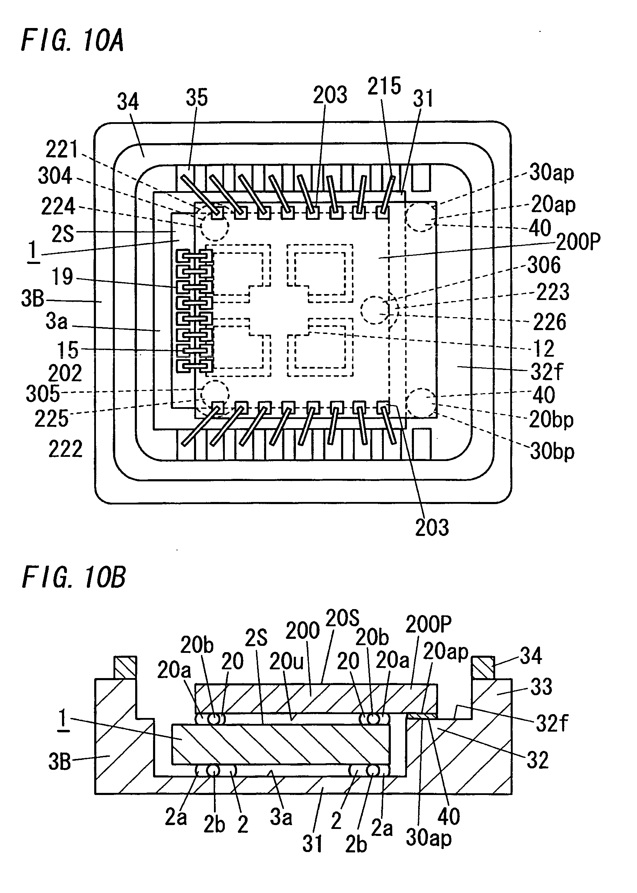

Fig. 10 shows a second modification of this embodiment. In this modification, the lower surface of the overlapping portion **200P** is provided at its both width ends of the acceleration sensor **1** with an overlapping spots **20ap, 20bp.** Consequently, the overlapping spots **20ap, 20bp** are located in two corners of the IC chip **200.** According to this, the step upper surface **32f** is provided with the arrangement spots **30ap, 30bp** which are faced to the overlapping spots **20ap, 20bp,** respectively. In addition, the seventh adhesive agents **40** are preferably disposed such that the seventh adhesive agents **40** are located between "the overlapping spot **20ap** and the arrangement spot **30a",** and between "the overlapping spot **20bp** and the arrangement spot **30a",** respectively. Consequently, even if the stress is caused by the shrinkage when the seventh adhesive agent is solidified, it is possible to prevent the stress from being applied to the IC chip **200.** In addition, even if the stress is caused according to the temperature variation of the substrate, it is possible to prevent the stress from being applied to the IC chip **200** through the seventh adhesive agent.

### (THIRD EMBODIMENT)

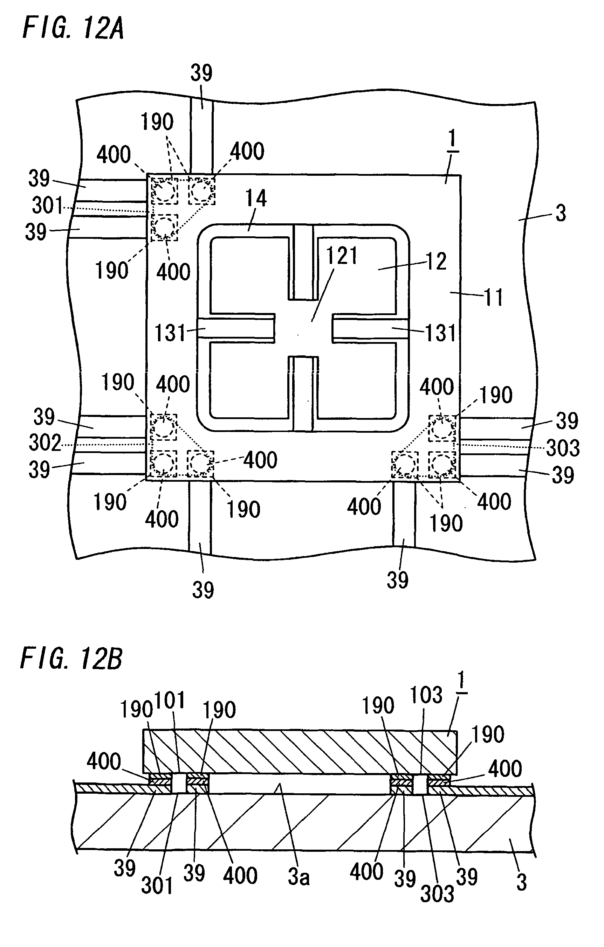

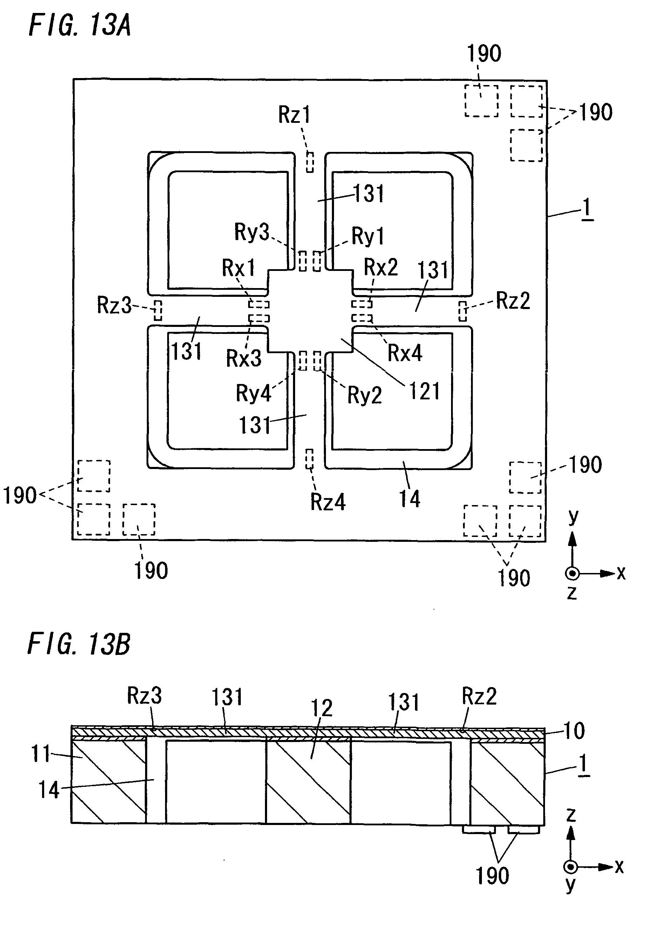

The module with mounting structure of chip in the third embodiment of this invention is explained with attached drawings. It is noted that the components in this embodiment in common with the components in the first embodiment are symbolized by the same reference numerals, whereby the explanation is omitted. As will be understood from Fig. 12 and Fig. 13, the module in this embodiment comprises the substrate **3,** the bump **400,** and the acceleration sensor **1.**

The substrate **3** further comprises a plurality of wirings **39.** A plurality of the wirings **39** is disposed on the upper surface of the substrate **3.** One end of each the wiring acts as a connecting electrode. The connecting electrodes are located in the first arrangement spot **301** or the second arrangement spot **302** or the third arrangement spot **303.** In addition, the connecting electrodes are provided at its upper surface with bumps **400,** respectively.

The bump **400** acts as the adhesive agent. The bump **400** is made of a solder. As will be understood from Fig. 12A, the bump **400** is disposed on the upper surface of one end of each the wiring **30.** That is, the bumps **400** are disposed on the first arrangement spot **301,** the second arrangement spot **302,** and the third arrangement spot **303,** respectively.

The acceleration sensor **1 B** further comprises a plurality of terminal electrodes **190.** The terminal electrodes **190** are located on the first adhesion spot **101,** the second adhesion spot **102,** and the third adhesion spot **103,** respectively. Further, as shown in Fig. 12A, the acceleration sensor **1** is disposed on the upper surface of the substrate **3** such that each the terminal electrode **190** is faced to the connecting electrode on one end of each the wiring **39.** The input terminal **VDD,** the output terminal **X1** to **Z2,** and the ground (earth) **GND** are connected to each the terminal electrode **190** via the wiring in the through hole which penetrates the frame **11** and which extends in the thickness direction of the frame **11.** Each the terminal electrode **190** is connected to the power source in the outside of the module, the voltage detection circuit, and the ground electrode (earth electrode) through the wiring which is not shown in the illustration. The power source in the outside of the module is configured to apply the voltage to the input terminal **VDD.** The ground (earth) **GND** is connected to the ground electrode (earth electrode) in the outside of the module. The output terminal **Z1** to **Z2** is connected to the voltage detection circuit in the outside of the module. The voltage detection circuit is configured to detect the accelerations in X-direction, Y-direction, and Z-direction on the basis of the variation of the voltage which is output from the bridge circuit **Bx, By,** and **Bz.**

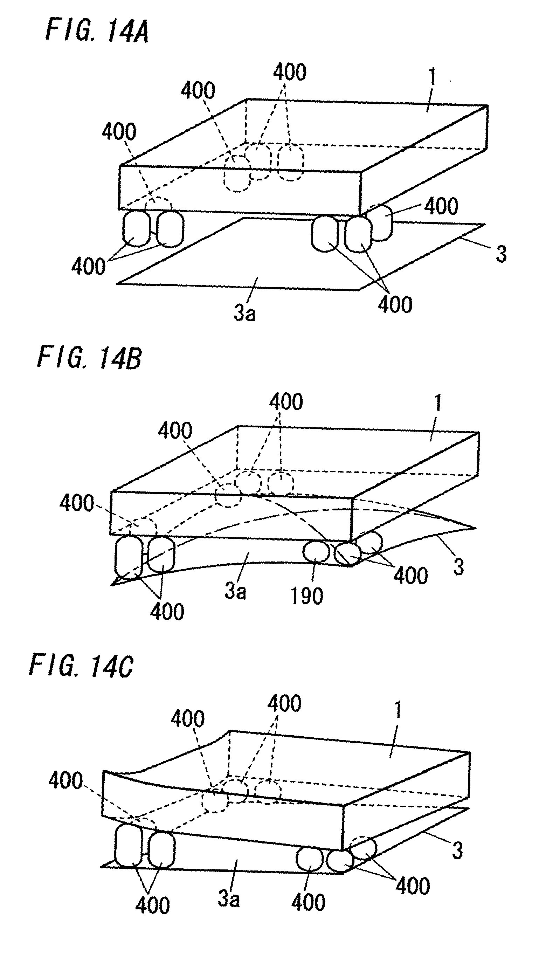

The acceleration sensor **1** is mounted on the substrate **3** as follows. Firstly, as will be understood from Fig. 14A, the bump **400** is provided to the lower surface of each the terminal electrode **190.** Then, the acceleration sensor **1** is disposed on the supper surface of the substrate **3** such that "the connecting electrode in one end of each the wiring **39",** "each the bump **400",** and "each the terminal electrode **190"** are aligned with each other in the thickness direction of "the substrate **3** and the acceleration sensor **1".** Then, the substrate **3,** the bump **400,** and the acceleration sensor **1** are heated at a predetermined temperature. When the substrate **3,** the bump **400,** and the acceleration sensor **1** are heated, as shown in Fig. 14B, the heat causes the warpage of the substrate. Subsequently, the substrate **3,** the bump **400,** and the acceleration sensor **1** are cooled to a room temperature. Consequently, the acceleration sensor **1** is bonded to the substrate having the warpage through the bump **400.** However, the acceleration sensor **1** is adhered to the substrate **3** through only three spots. Therefore, when the substrate **3** is changed from the warpage condition into flat condition, the stress is caused. However, the acceleration sensor **1** is fixed to the substrate such that the acceleration sensor **1** has an inclination with respect to the substrate **3.** This inclination releases the stress. In addition, this inclination is nanometer level. Therefore, the inclination causes no effect to the detection accuracy of the acceleration sensor **1.**

As mentioned above, the module with mounting structure of chip in this embodiment of this embodiment makes it possible to prevent the warpage of the substrate when mounting the first chip. Therefore, it is possible to prevent the deformation of the first chip. Consequently, it is possible to obtain the module with the first chip which is free from the stress after mounting on the substrate.

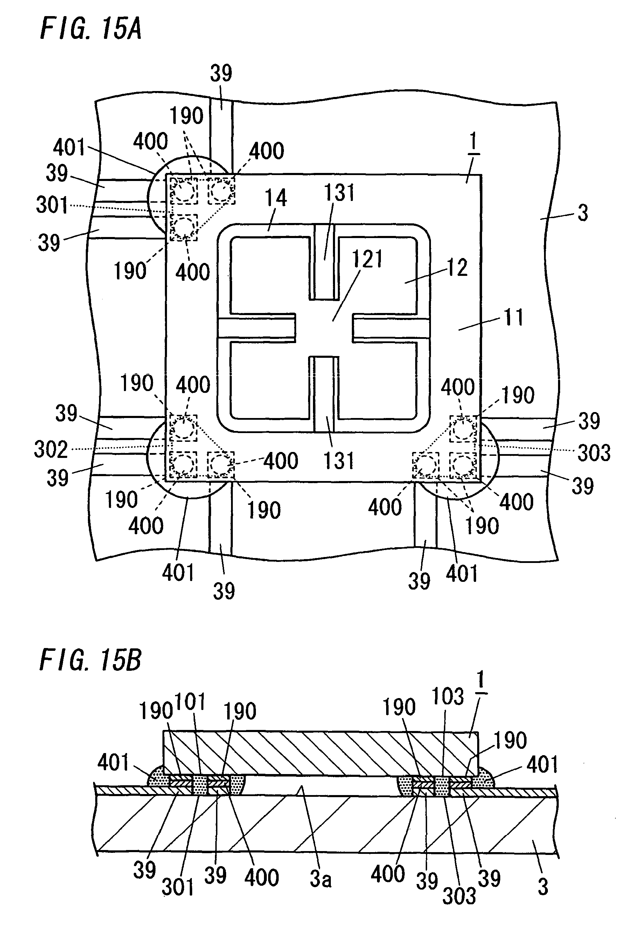

Fig. 15 shows a first modification of this embodiment. The module in this modification further comprises an encapsulation resin **401.** As shown in Fig. 15B, the encapsulation resins **401** are located in positions "between the first arrangement spot **301** and the first adhesion spot **101",** "between the second arrangement spot **302** and the second adhesion spot **102",** and "between the third arrangement spot **303** and the third adhesion spot **103".** Consequently, the encapsulation resins **401** encapsulate the bumps **400.**

The acceleration sensor **1** is mounted on the substrate **3** as follows. Firstly, the bump **400** and the encapsulation resin **401** are formed on the lower surface of each the terminal electrode **190.** Then, the acceleration sensor **1** is disposed on the upper surface of the substrate **3** such that "one end of each the wiring **39",** "each the bump **400",** and "each the terminal electrode **190"** are aligned with each other in the thickness direction of "the substrate **3** and the acceleration sensor **1".** Then, the substrate **3,** the bump **400,** and the acceleration sensor **1** are heated to a predetermined temperature. When the substrate **3,** the bump **400,** and the acceleration sensor **1** are heated, as shown in Fig. 14 B, the heat causes the warpage of the substrate **3.** Then, the substrate **3,** the bump **400,** and the acceleration sensor **1** are cooled at room temperature. Consequently, the acceleration sensor **1** is adhered to the substrate **3** with the warpage through the bump **400.** However, the acceleration sensor **1** is adhered to the substrate **3** through the three spots. When the substrate **3** having the warpage condition is changed into the flat condition, the stress is caused. However, the acceleration sensor **1** is fixed to the substrate such that the acceleration sensor **1** has an inclination with respect to the substrate. Therefore, the stress is released by the inclination. When the substrate **3** is changed from the warpage condition into the flat condition, there is a possibility of causing the contact failure of the bump **400** with respect to the terminal electrode **190.** However, the encapsulation resin **401** is located between each the arrangement spot and each the adhesion spot. Therefore, it is possible to stably establish the electrical connection of the bump **400** with respect to the terminal electrode **190.**

As explained above, the module with mounting structure of chip in this modification makes it possible to prevent the contact failure of the bump **400** with respect to one end of the wiring **39** when the substrate is changed from the warpage condition into the flat condition under a condition where the acceleration sensor **1** is mounted.

In addition, in the module of this embodiment, a plurality of the bumps **400** are disposed on the first arrangement spot **301,** are disposed on the second arrangement spot **302,** and are disposed on the third arrangement spot **303.** However, it is preferred that at least one of the arrangement spots is provided with a plurality of the bumps **400.** Consequently, it is possible to prevent the local deformation of the acceleration sensor **1.**

In addition, this embodiment discloses the bump **400** which is made of the solder. However, the bump **400** is not limited its material to the solder. The bump made of metal material such as Au may be employed as the bump. Furthermore, it is possible to employ the bump made of the electrical conductive paste of silicone series resin may be employed as the bump. Especially, when the bump made of electrical conductive paste having the silicone series resin is employed, it is possible to reduce the effect to the acceleration sensor **1** due to the stress caused by the temperature variation of the substrate. In addition, when the bump made of the electrical conductive paste of silicone series resin is employed, it is possible to establish the stable connection of the bump with respect to the terminal electrode **190.**

Needless to say, the features of the above embodiments and the modifications explained in the above may be combined arbitrarily.

## Claims

1. A mounting structure of chip comprising:
a substrate having a base;
a first chip being disposed on an upper side of said base;
an adhesive agents for bonding said first chip and said base,
wherein
said adhesive agents are disposed on an upper surface of said base,
said first chip having a rectangular shape to have a width and a length,
a lower surface of said first chip and said base being bonded by said adhesive agents,
said adhesive agents comprising only a first adhesive agent, a second adhesive agent, and a third adhesive agent, said first adhesive agent, said second adhesive agent, and
said third adhesive agent being disposed on three spots of the upper surface of said base, respectively, said three spots of the upper surface of said base being arranged in a position of corners of a triangle,
wherein
said first chip is bonded with respect to said base by only said first adhesive agent, said second adhesive agent, and said third adhesive agent.

2. The mounting structure of chip as set forth in claim 1, wherein
said first chip further comprises a plurality of first pad electrodes, a plurality of said first pad electrodes being disposed on an upper surface of said first chip,
said first adhesive agent and said second adhesive agent are located in one end of a length direction of the lower surface of said first chip and said third adhesive agent is located in the other end of the length direction of the lower surface of said first chip, said first adhesive agent is located in one end of a width direction of the lower surface of said first chip and said second adhesive agent is located in the other end of the width direction of the lower surface of said first chip,
all said first pads are arranged in the width direction of the upper surface of said first chip such that all said first pads are arranged between said first adhesive agent and said second adhesive agent, all said first pads are located in a position of one end of the length direction of the first chip so as to be located away from said third adhesive agent.

3. The mounting structure of chip as set forth in claim 1, wherein
said first chip further comprises a plurality of first pads, a plurality of said pads being disposed on an upper surface of the first chip,
said first adhesive agent and said second adhesive agent are located in one end of a length direction of the lower surface of said first chip and said third adhesive agent is located in the other end of the length direction of the lower surface of said first chip, said first adhesive agent is located in one end of a width direction of the lower surface of said first chip and said second adhesive agent is located in the other end of the width direction of the lower surface of said first chip, said third adhesive agent being located in one end of the width direction of the lower surface of said first chip,
a plurality of said first pads comprising a first electrode row and a second electrode row, said first electrode row, said first adhesive agent, and said second adhesive agent are arranged in the width direction of said first chip,
said second electrode row, said first adhesive agent, and said third adhesive agent are arranged in the length direction of said first chip.

4. A module comprising the mounting structure of chip as set forth in claim 1, wherein said module comprises a second chip, a fourth adhesive agent, a fifth adhesive agent, and a sixth adhesive agent in addition to said substrate, said first chip, said first adhesive agent, said second adhesive agent, and said third adhesive agent,
said fourth adhesive agent, said fifth adhesive agent, and said sixth adhesive agent are disposed on three spots, respectively, of an upper surface of said first chip, said three spots on the upper surface of said first chip are located in a corner of a triangle,
said first chip further comprises a plurality of first pad electrodes which are disposed on the upper surface of said first chip,
wherein
said second chip and said first chip are bonded by said fourth adhesive agent, said fifth adhesive agent, and said sixth adhesive agent such that all said first pad electrodes are exposed to an upper direction of said first chip.

5. The module as set forth in claim 4, wherein
said first adhesive agent is aligned with said fourth adhesive agent in a thickness direction of said first chip,
said second adhesive agent being aligned with said fifth adhesive agent in the thickness direction of said second chip,
said third adhesive agent being aligned with said sixth adhesive agent in the thickness direction of said third chip.

6. The module as set forth in claim 4, wherein
said substrate comprises a step and a peripheral wall,
said step extends in an upper direction from an outer end of the base, said step has a step upper surface, said step upper surface is located at a first height from an upper surface of said base,
said peripheral wall extending toward the upper direction from an entire circumference of said base and said step such that said peripheral wall surrounds said base and said step, said second chip has a rectangular shape to have a width and a length, said second chip has one end in a length direction of said second chip and a remaining end in the length direction of said second chip, said one end in the length direction of said second chip being defined as an overlapping portion, said remaining end in the length direction of said second chip being adhered to said first chip through said fourth adhesive agent and said fifth adhesive agent, said overlapping portion having a lower surface which is located at a second height from an upper surface of said base, said second height is higher than said first height,
said second chip being disposed on the upper surface of said first chip such that said overlapping portion is overlapped with said upper step upper surface,
said module has a seventh adhesive agent, said seventh adhesive agent being disposed between said lower surface of said overlapping portion and said step upper surface, said seventh adhesive agent bonding said lower surface of said overlapping portion and said step upper surface.

7. The module as set forth in claim 6, wherein
said fourth adhesive agent is located in one width end of said lower surface of said second chip and said fifth adhesive agent is located in a remaining width end of said lower surface of said second chip.

8. The module as set forth in claim 6, wherein
said seventh adhesive agent is disposed on one width end of said second chip and a remaining width end of said second chip, only, such that said seventh adhesive agent is located in two corners of said second chip.

9. The mounting structure of chip as set forth in claim 1, wherein
said substrate further comprises connecting electrodes which are disposed on three spots of said substrate, respectively,
said first chip further comprises a plurality of terminal electrodes which is disposed on a lower surface of said first chip, whereby said terminal electrodes are located in positions corresponding to positions of said connecting electrodes,
said first adhesive agent, said second adhesive agent, and said third adhesive agent being defined by bumps, respectively,
each said terminal electrode being connected to each said connecting electrode through said bump.

10. The mounting structure of chip as set forth in claim 9, wherein
said first chip is a MEMS device which has a movable portion,
said MEMS device comprising a plurality of first pad electrodes,
each said first pad electrode being disposed to be spaced from said movable portion.

11. The mounting structure of chip as set forth in claim 9, wherein
each one of said first adhesive agent, said second adhesive agent, and said third adhesive agent further comprises encapsulation resin, said encapsulation resins being configured to encapsulate said bumps.

12. The mounting structure of chip as set forth in claim 1, wherein
said substrate further comprises projections, said projections being projected toward an upper direction from said upper surface of said base,
said projections being disposed on the three spots of the upper surface of said base, said first adhesive agent, said second adhesive agent, and said third adhesive agent are disposed on only the three spots of the upper surface of said base such that said first adhesive agent, said second adhesive agent, and said third adhesive agent covering said projections.

13. The mounting structure of chip as set forth in claim 1, wherein
said first adhesive agent, said second adhesive agent, and said third adhesive agent comprise a silicone series resin.

14. The mounting structure of chip as set forth in claim 1, wherein
said first adhesive agent, said second adhesive agent, and said third adhesive agent comprise resin and spacers, said spacers having spherical shapes.

15. The mounting structure of chip as set forth in claim 14, wherein
said spacer is made of glass or plastic.

16. The mounting structure of chip as set froth in claim 1, wherein
said first adhesive agent, said second adhesive agent, and said third adhesive agent are located in a circumference of said first chip.

17. The module as set forth in claim 4, wherein
said fourth adhesive agent, said fifth adhesive agent, and sixth adhesive agent comprise a silicone series resin.

18. The mounting structure of chip as set forth in claim 9, wherein
at least one of said first adhesive agent, said second adhesive agent, and said third adhesive agent comprises a plurality of said bumps.

19. The mounting structure of chip as set forth in claim 9, wherein
said bump is located in a position corresponding to an outer circumference of the lower surface of the first chip.

20. The mounting structure of chip as set forth in claim 9, wherein
said bump is made of a solder.

21. The mounting structure of chip as set forth in claim 9, wherein
said bump is made of an electrical conductive paste of silicone series.

22. The mounting structure of chip as set forth in claim 1, wherein
said first adhesive agent, said second adhesive agent, and said third adhesive agent cover a lower portion of a side surface of the first chip.
